# EUROPÄISCHE PATENTSCHRIFT

(11) **EP 0 829 120 B1**
(45) Veröffentlichungstag und Bekanntmachung des Hinweises auf die Patenterteilung: **20.01.1999**
(21) Anmeldenummer: 96913514.4
(22) Anmeldetag: 19.04.1996
(51) Int. Cl.: H01S 3/085

(54) **DURCHSTIMMBARE, JUSTIERSTABILE LASERLICHTQUELLE MIT SPEKTRAL GEFILTERTEM AUSGANG**
TUNEABLE, ADJUSTMENT-STABLE LASER LIGHT SOURCE WITH A SPECTRAL FILTERED OUTPUT
SOURCE ACCORDABLE DE LUMIERE LASER A REGLAGE STABLE ET A SORTIE SPECTRALE FILTREE

(30) Priorität: 20.04.1995 DE 19515321
(43) Veröffentlichungstag der Anmeldung: 18.03.1998
(73) Patentinhaber: Gabbert, Manfred, 10249 Berlin (DE)
(72) Erfinder: Gabbert, Manfred, 10249 Berlin (DE)
(74) Vertreter: Hengelhaupt, Jürgen, Dipl.-Ing.
(86) Internationale Anmeldenummer: EP9601640
(87) Internationale Veröffentlichungsnummer: WO9633536

(56) Entgegenhaltungen:
- EP-A- 0 347 213
- US-A- 4 246 548
- IEEE JOURNAL OF QUANTUM ELECTRONICS, FEB. 1982, USA, Bd. QE-18, Nr. 2, ISSN 0018-9197, Seiten 155-157, XP002012780 SATO H ET AL: "Design of nondispersion optical feedback system using diffraction grating for semiconductor laser multiple longitudinal modes control"
- ELECTRONICS LETTERS, Bd. 29, Nr. 10, 13.Mai 1993, Seiten 930-931, XP000367679 "FOUR CHANNEL MULTIWAVELENGTH SOURCE WITH INDIVIDUALLY ADDRESSABLE ELEMENTS"
- ELECTRONICS LETTERS, Bd. 27, Nr. 16, 1.August 1991, Seiten 1461-1462, XP000259874 YEATMAN E M ET AL: "OPTIMAL TRANSVERSE MODE CONTROL OF WAVEGUIDE ARRAY LASERS BY DISCRETE TRANSFORM TECHNIQUES"
- OPTICS LETTERS, Bd. 16, Nr. 12, 15.Juni 1991, Seiten 910-912, XP000216266 HARVEY K C ET AL: "EXTERNAL-CAVITY DIODE LASER USING A GRAZING-INCIDENCE DIFFRACTION GRATING"
- OPTICS LETTERS, OCT. 1988, USA, Bd. 13, Nr. 10, ISSN 0146-9592, Seiten 826-828, XP002012781 ZORABEDIAN P ET AL: "Interference-filter-tuned, alignment-stabilized, semiconductor external-cavity laser" in der Anmeldung erwähnt

## Beschreibung

Die Erfindung betrifft eine durchstimmbare Laserlichtquelle, die sich durch hohe optische Stabilität sowie besondere Unterdrückung der breitbandigen spontanen Strahlung (ASE-Amplified Spontaneous Emission) und der Nebenmoden bei einfachem Aufbau auszeichnet. Anwendungsgebiet für eine derartige Lichtquelle ist u. a. die Ramanspektroskopie.

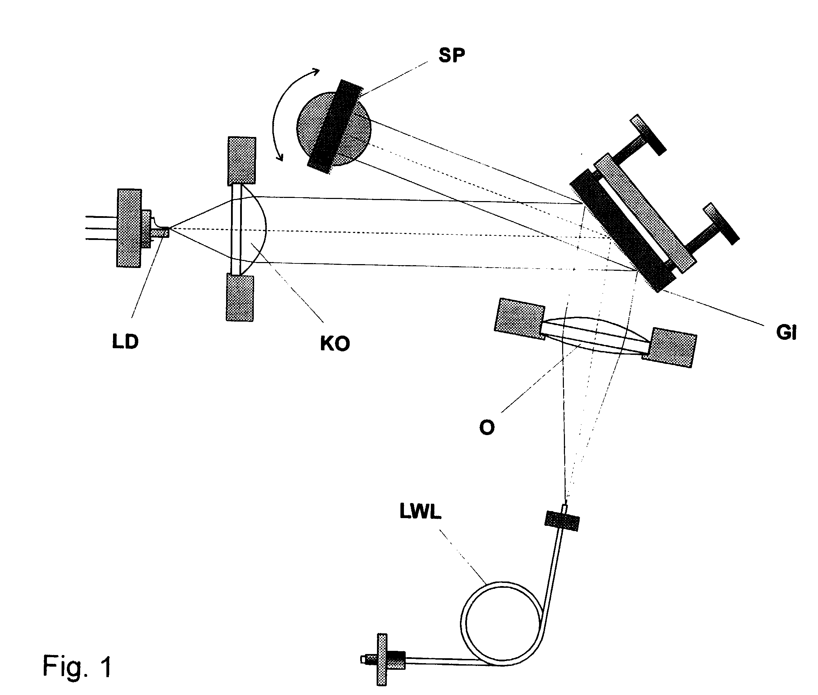

Durchstimmbare Laserlichtquellen sind in vielen Varianten bekannt. Als Beispiel ist in Fig. 1 eine Halbleiterlaseranordnung gezeigt. Entsprechend abgewandelt, wird dieser Aufbau auch für Farbstofflaser verwendet. Sie besteht im wesentlichen aus der Laserdiode LD, einem Kollimator KO, einem Beugungsgitter GI zur Dispersion der Laserstrahlung und einem in Dispersionsrichtung des Gitters drehbaren ebenen Spiegel SP. Die nach dem Kollimator KO im wesentlichen ein paralleles Bündel bildende Laserstrahlung wird am Gitter GI gebeugt und gelangt auf den drehbaren Spiegel SP. Nur die Laserwellenlängen, die derart gebeugt worden sind, daß sie den Spiegel SP weitestgehend senkrecht treffen, laufen hinreichend genau wieder auf demselben Weg zurück und werden auf die aktive Laserfacette abgebildet, wodurch eine optische Rückkopplung entsteht. Damit läßt sich allein durch Drehen des Spiegels SP in Dispersionsrichtung des Gitters GI der rückgekoppelte Wellenlängenbereich und damit die Hauptemissionswellenlänge der Anordnung wählen.

Die nutzbare Laserstrahlung wird dagegen über die nullte Beugungsordnung des Gitters ausgekoppelt, wozu beispielsweise eine Optik O die Strahlung in einen Lichtwellenleiter LWL fokussiert. Unabhängig von der Wellenlängeneinstellung erscheint die nutzbare Strahlung immer am selben Ort.

Nachteil derartiger Anordnungen, die in dieser oder ähnlicher Art weit verbeitet sind, ist zum einen die hohe Empfindlichkeit schon gegen geringfügige Dejustierungen. Da z.B. die optisch wirksame Facette eines Halbleiterlasers sehr klein ist, ist eine besondere Stabilität des Aufbaus hinsichtlich Verkippungen des Strahlenganges senkrecht zur Dispersionsrichtung nötig. Das betrifft die Lagerung des drehbaren Spiegels, die Stabilität der Gitterhalterung, des Lasers sowie des Kollimators. Bei derartigen Aufbauten sind drei Freiheitsgrade zu kontrollieren, wovon nur einer zwingend notwendig ist, nämlich die Drehung des Spiegels zur Wellenlängendurchstimmung. Die Verschiebung des Lasers senkrecht zur Dispersionsrichtung des dispergierenden Elementes sowie die zur Fokussierung notwendige Verschiebung des Laserchips entlang der optischen Achse sind in optimaler Stellung zu halten, ohne daß sie die Verstellung irgeneines Ausgangsparameters gestatten. Erschwerend ist dabei, daß diese beiden unabhängig verstellbaren Koordinaten nicht voneinander getrennt optimierbar sind, sondern es naturgemäß innerhalb dieser zweidimensionalen Justiermöglichkeit nur eine optimale Stellung gibt. Oft wird für diese Aufgabe eine gesonderte Regelung benutzt.

Ein weiterer Nachteil derartiger Anordnungen besteht darin, daß nicht spektral gereinigte Strahlung, sondern ein Anteil des gesamten Strahlungsgemisches, das sich im Resonator befindet, einschließlich der spontanen Emission und mehr oder weniger starker Nebenmoden, als nutzbare Strahlung aus dem Resonator geführt wird. Da die Auskopplung der Strahlung zudem über einen anderen Zweig als die Rückkopplung erfolgt, können ohne zusätzliche Mittel kaum vermeidbare Reflexionen von der externen Anordnung, in der die Laserstrahlung verwendet wird, die Strahlung im Resonator stark beeinflussen, wobei eine solche Rückkopplung üblicherweise nicht wellenlängenselektiv erfolgt. Dies gilt naturgemäß besonders bei Vorhandensein einer optischen Abbildung der Laserfacette auf eine zumindest teilreflektierende, nicht notwendig spiegelnde Fläche (z.B. Lichtwellenleiter, Empfängerflächen), da derartige Aufbauten als Retroreflektor wirken.

Es sind Lösungen bekannt, die entweder die Gewinnung weitgehend spektral reiner Strahlung erlauben, als auch solche, die mit besonderen Maßnahmen die Justiertoleranz eines solchen Laserresonators erhöhen und so den Aufbau eines vergleichsweise robusten Gerätes gestatten. Eine Anordnung, die beide dieser Merkmale vereint, ist jedoch noch nicht bekannt.

Den Stand der Technik zur Gewinnung spektral reiner Strahlung verkörpert in diesem Zusammenhang die DE-AS 29 18 863. Bei dieser Erfindung wird im wesentlichen die Strahlung, die den Resonator schon verlassen hat, in eine Vorrichtung zu ihrer spektralen Reinigung geleitet, wobei insbesondere das zur Wellenlängenselektion des Lasers dienende dispergierende Element von dieser Vorrichtung ebenfalls unter zumindest weitgehend gleichen Bedingungen benutzt wird. Dadurch wird erreicht, daß unabhängig von der Wellenlängeneinstellung des Lasers automatisch die entsprechend gefilterte Strahlung die Anordnung verläßt. Nachteil ist jedoch noch, daß im wesentlichen nur das dispergierende Element doppelt benutzt wird und damit noch immer verschiedene zusätzliche Bauteile zur Umleitung der Strahlung in den Filtermechanismus und für diesen selbst erforderlich sind. In einer Variante ist in der genannten DE-AS 29 18 863 eine Anordnung beschrieben, bei der ein Teil der gefilterten Strahlung im Resonator verbleibt bzw. in diesen zurückgeführt wird. Auch hierbei sind jedoch bis auf das dispergierende Element noch Laser und Filtervorrichtung beide vorhanden. Darüber hinaus verläßt auch ein wesentlicher Anteil nichtgefilterter Strahlung den Resonator über einen notwendigerweise vorhandenen Teilerspiegel, wodurch dieser Anteil verloren geht.

Ebenfalls mit der Gewinnung spektral gereinigter Strahlung befaßt sich die DE-OS 42 16 001 A1. Hierbei laufen Gesamt strahlung im Resonator und spektral gereinigter Anteil unter verschiedenen Winkeln durch den Resonator, so daß diese getrennt werden können. Hierbei werden jedoch mehrere Bauteile unter streifendem Einfall betrieben, was die Anwendbarkeit dieser Erfindung beeinträchtigt. Außerdem durchläuft auch die spektral gereinigte Strahlung unmittelbar vor der Auskopplung noch einmal das Lasermedium, wodurch die spektrale Reinheit wieder in Frage gestellt wird.

Der Stand der Technik zur Erhöhung der Justiertoleranz bei Lasern mit externen Resonatoren wird im wesentlichen von zwei Lösungen bestimmt:

Die erste Lösung ist in P. Zorabedian and W. R. Trutna, Jr. : Interference-filter-tuned, alignment-stabilized, semiconductor external-cavity laser, OPTICS LETTERS / Vol. 13, No. 10, pp 826...828 beschrieben. Zur justiertoleranten Rückkopplung der Laserstrahlung wird ein Katzenaugen-Retroreflektor (sammelnde Optik mit Spiegel in deren Brennebene) benutzt. Als selektives Element befindet sich im parallelen Strahlengang innerhalb des Resonators ein Interferenzfilter. Zur Durchstimmung der Laserwellenlänge ist dieses Filter drehbar gelagert. Die Auskopplung der nutzbaren Srahlung erfolgt aus der dem externen Resonator abgewandten Facette des Laserchips.

Nachteile dieser Anordnung sind jedoch, daß die breitbandige spontane Emission sowie die Nebenmoden nicht ohne wesentliche weitere Mittel von der nutzbaren Strahlung zu trennen sind sowie die Beschränkung durch die Eigenschaften eines Interferenzfilters.

Eine weitere Möglichkeit zum Aufbau eines justierstabilen Lasers mit externem Resonator beinhaltet die EP 0 525 752 A1. Hierbei wird im Prinzip ebenfalls ein Katzenaugen-Retroreflektor angewandt, seine Wirkung jedoch auf eine Koordinate begrenzt. Durch eine geeignete Kombination aus Prismen und einer Zylinderoptik zur Strahlformung sowie den Einsatz eines Beugungsgitters als Reflektor ergibt sich, daß eine Abbildung der Laserfacette auf das Gitter nur senkrecht zur Dispersionsrichtung erfolgt. In Dispersionsrichtung ist das das Gitter treffende Strahlbündel jedoch weitestgehend parallel und relativ breit. Auf diese Weise wird erreicht, daß das Gitter ohne Einschränkung zur Durchstimmung der Laserwellenlänge benutzt werden kann, andererseits die Anordnung weitgehend tolerant gegenüber einer Gitterkippung senkrecht zur Dispersionsrichtung ist. Auch dieser Aufbau gestattet ohne zusätzliche Mittel keine Abtrennung der breitbandigen spontanen Strahlung und der Nebenmoden aus dem nutzbaren Strahlungsanteil.

Eine durchstimmbare Laserlichtquelle und ein entsprechendes Verfahren mit allen im Oberbegriff des Anspruchs 1 bzw. des Anspruchs 17 angegebenen Merkmalen und Schritten sind aus Electronics Letters, Bd. 29, Nr. 10, 13 Mai 1993, Seiten 930-931 bekannt.

Der Erfindung liegt daher die Aufgabe zugrunde, eine Resonatoranordnung für ein breitbandig verstärkendes, schmalbandig durchstimmbares Lasermedium, insbesondere Halbleiterlaser, zu finden, die sich bei einfachem Aufbau durch hohe Justiertoleranz als auch gleichzeitig durch weitgehende Freiheit von ASE und Nebenmoden auszeichnet.

Diese Aufgabe wird durch die Merkmale im kennzeichnenden Teil der Haupt ansprüche in Verbindung mit den Merkmalen im jeweiligen Oberbegriff gelöst. Zweckmäßige Ausgestaltungen der Erfindung sind in den Unteransprüchen enthalten.

Dabei ist von besonderem Vorteil, daß die kollimierte Laserstrahlung ein winkel- bzw. lineardispergierendes Element durchläuft und danach in einen besonderen Katzenaugen-Retroreflektor gelangt, der am Ort seines Reflektors ein Raumfilter enthält, derart, daß im Zusammenhang mit der Dispersion des dispergierenden Elementes nur spektral gefilterte Strahlung das Raumfilter passiert und außerdem der genannte Reflektor teildurchlässig ausgeführt ist, so daß dieselbe, selektierte Strahlung sowohl zur justierstabilen Rückkopplung dient sowie als nutzbarer Anteil aus dem Resonator geführt wird. Da der von der Auskoppelfläche in den Resonator reflektierte Strahlungsanteil zugleich für die Rückkopplung vorgesehen ist, entfällt das Problem unerwünschter Reflexionen an der Auskoppelfläche. Eventuelle Reflexionen aus der die nutzbare Strahlung verarbeitenden Anordnung wirken sich auch ohne weitere Mittel ebenfalls nur wenig störend aus, da diese eventuelle Stör-Rückkopplung ausschließlich die selektierte Wellenlänge enthält.

Die Erfindung soll im folgenden an mehreren Ausführungsbeispielen erläutert werden.

Es zeigen:
- Fig. 1: eine durchstimmbare Laserlichtquelle gemäß dem bekannten Stand der Technik
- Fig. 2: eine schematische Darstellung der Grundvariante der Erfinung
- Fig. 3: eine schematische Darstellung einer ersten Ausführungsvariante
- Fig. 4: eine schematische Darstellung einer zweiten speziellen Ausführungsvariante
- Fig. 5: eine schematische Darstellung einer dritten speziellen Ausführungsvariante
- Fig. 6: eine schematische Darsellung einer vierten speziellen Ausführungsvariante
- Fig. 7: eine schematische Darstellung einer speziellen Anordnung des Lasermediums
- Fig. 8: eine schematische Darstellung einer weiteren speziellen Anordnung des Lasermediums.

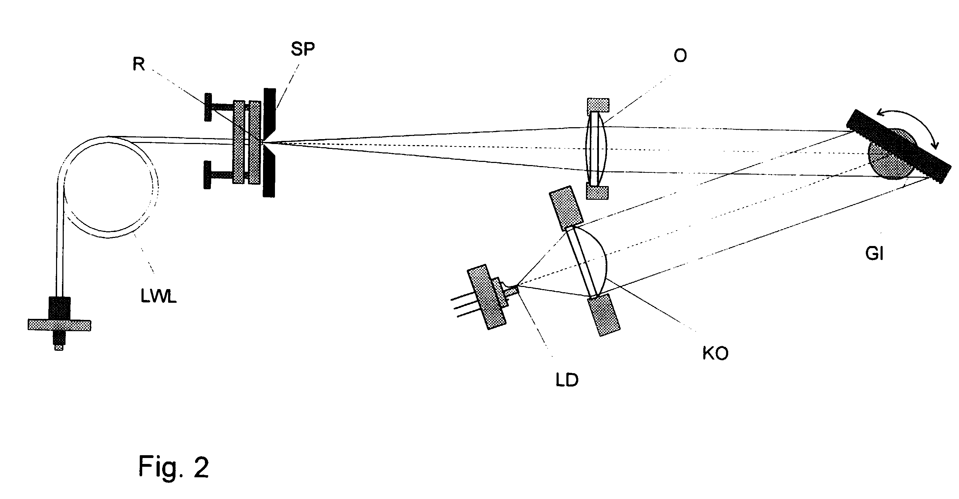

Die Grundvariante der Erfindung ist in Fig. 2 dargestellt. Die Strahlung der aus dem Lasermedium LD, im vorliegenden Ausführungsbeispiel eine Laserdiode, wird durch den Kollimator KO, der eine beugungsbegrenzte Abbildung erlaubt und zweckmäßig aus einer Asphäre besteht, zunächst in ein im wesentlichen paralleles Bündel überführt. Dieses Bündel gelangt auf das in Dispersionsrichtung drehbar angeordnete dispergierende Element GI, hier ein Beugungsgitter, welches wiederum zweckmäßig für eine sehr hohe Effektivität für den vorgesehenen Wellenlängenbereich bei der vorhandenen Polarisationsrichtung ausgelegt ist. Des geringen Streulichtanteils wegen ist hierfür ein holographisch hergestelltes Gitter besonders geeignet. Die gebeugte Strahlung der jeweils selektierten Wellenlänge gelangt in einen Teil O des abbildenden Systems, im vorliegenden Ausführungsbeispiel eine ebenfalls beugungsbegrenzte Optik, die ein Bild der optisch wirksamen Laserfacette in der Ebene des als Spalt ausgebildeten Raumfilters SP entwirft. Der Spalt SP läßt nur Strahlung eines eng begrenzten Wellenlängenintervalls um die selektierte Wellenlänge passieren. Zweckmäßig wird ein solcher Spalt SP gewählt, der den Strahlungsanteil, den er nicht hindurchläßt, auch nicht reflektiert. Dies läßt sich durch Schwärzung des Spaltes SP und / oder eine geeignete Geometrie der Spaltbacken erreichen. Im wesentlichen in derselben Ebene wie der Spalt SP befindet sich die eben polierte, teilverspiegelte Stirnfläche eines Lichtwellenleiters LWL. Der Anteil von reflektierter zu durchgelassener Strahlung läßt sich für den Gesamtresonator durch Herstellung der entsprechenden Teilverspiegelung optimieren. Die Fläche des Reflektors R sorgt nun zusammen mit dem Spalt SP für die selektive Rückkopplung. Zugleich wird die derart gefilterte Strahlung als nutzbare Strahlung in den Lichtwellenleiter LWL eingespeist. Justierabweichungen, die in einer Kippung des Gitters GI senkrecht zur Dispersionsrichtung oder gleichwirkenden Fehlern oder in einer Kippung der Lichtwellenleiterfacette bestehen, wirken sich wegen des Katzenaugen-Retroreflektors nur vergleichsweise sehr wenig aus, wodurch die hohe Justierstabilität erreicht wird.

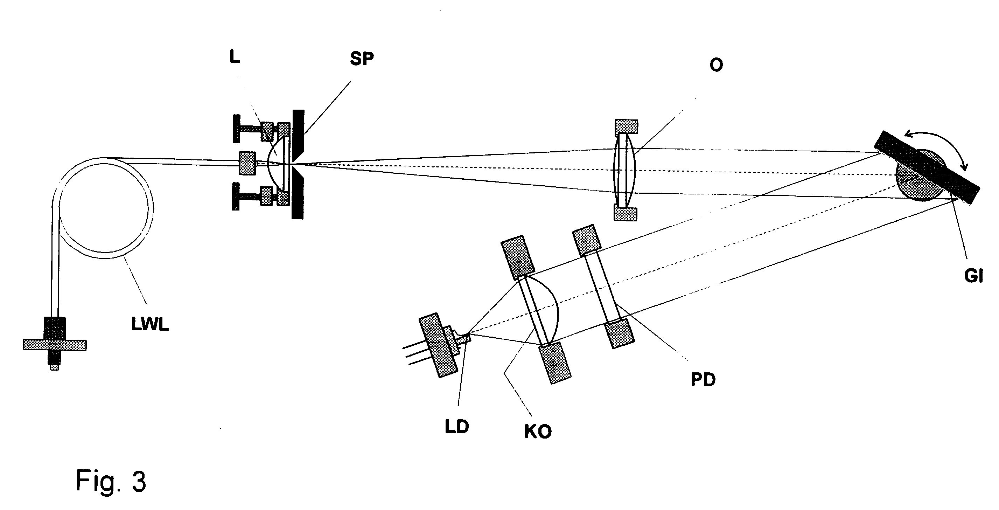

Für viele Einsatzfälle, insbesondere auch für die Ramanspektroskopie, wird spektral reine Strahlung bei robustem Aufbau und zugleich hoher verfügbarer Strahlungsleistung benötigt. Hierfür ist ein weiteres Ausführungsbeispiel (Fig. 3) vorgesehen. Als Lasermedium dient hierbei eine einseitig weitgehend entspiegelte Breitstreifen-Laserdiode. Da die optisch wirksame Facette einer derartigen Diode vielfach breiter als bei Kleinleistungs-Laserdioden ist (typ. z.B. 0,2 mm...0,5 mm gegenüber wenigen µm bei Laserdioden kleiner Leistung), ist eine Abwandlung der Resonatoranordnung erforderlich. Um im Zusammenhang mit der breiten Facette die angestrebte spektale Schmalbandigkeit zu erreichen, kommt nur eine Anordnung der Facette parallel zum Spalt SP und parallel zu den Gitterfurchen in Frage. Nun strahlen aber Halbleiterlaser üblicherweise mit dem E-Vektor parallel polarisiert zum pn-Übergang (die optisch wirksame Facette liegt ebenfalls in der Ebene des pn-Übergangs) Die höchste Beugungseffektivität des Gitters GI läßt sich aber im wesentlichen nur für den E-Vektor senkrecht zu den Gitterfurchen erreichen. Zur Lösung dieses Problems wird im parallelen Strahlengang zwischen Kollimator KO und Gitter GI ein geeigneter 90°- Polarisationsdreher PD, z.B. eine λ / 2 -Platte eingefügt. Wird nun der Aufbau so ausgelegt, daß er, wie oben beschrieben, spektrale Schmalbandigkeit der Selektion ermöglicht, wird die Polarisationsebene der Strahlung vor dem Erreichen des Gitters GI in die für hohe Beugungseffektivität notwendige Richtung gedreht. Nachdem das Gitter GI in Hin- wie Rückrichtung durchlaufen worden ist, wirkt der Polarisationsdreher PD abermals, so daß die rückgekoppelte Strahlung den Laser wieder mit der ursprünglichen Polarisationsrichtung trifft.

Ein weiteres Problem im Zusammenhang mit der Benutzung von Breitstreifenlasern besteht darin, daß in der Regel das Bild der Laserfacette so groß wird, daß eine Einkopplung in einen hinreichend dünnen Lichtwellenleiter LWL nicht mehr möglich ist. Nun ist durch die gegebenen Verhältnisse dieses Bild gegenüber der Originalfacette üblicherweise mehrfach vergrößert.

Das genannte Problem läßt sich daher dadurch beheben, daß die Laserfacette nicht auf ein Lichtwellenleiterende, sondern auf die ebene, teilverspiegelte Fläche einer als Plankonvexlinse ausgebildeten Auskoppeloptik L abgebildet wird. In der Brennebene dieser Linse L spielt es keine Rolle mehr, wie groß das Bild der Laserfacette auf der Linse L ist.

Die Größe des Brennflecks in der Brennebene der Linse L hängt hier nur von ihrer Brennweite und der Apertur der Strahlung ab, mit der das Bild der Laserfacette auf der Linse L erzeugt wurde. Im Zusammenhang mit der oben erwähnten vergrößerten Abbildung der Laserfacette bedeutet dies aber, daß diese Apertur vergleichsweise klein ist, so daß nach diesem Prinzip eine Einkopplung in einen hinreichend dünnen Lichtwellenleiter LWL erfolgen kann.

An Stelle eines Breitstreifenlasers kann ebenso eine Laserdiodenzeile benutzt werden. Dabei hat die erfindungsgemäße Anordnung den Vorteil, daß weitgehend jede Einzeldiode exakt mit sich selbst rückgekoppelt wird.

Eine weitere Ausgestaltung der Erfindung besteht darin, daß im wesentlichen eine Anordnung wie in Fig. 3 mit einer Laserdiodenzeile verwendet wird, jedoch mit dem Unterschied, daß als Rück- und Auskoppelelemente ähnlich wie in Fig. 2 die eben polierten, teilverspiegelten Enden von Lichtwellenleitern LWL benutzt werden, und zwar derart, daß dem Bild jeder Einzeldiode ein eigener Lichtwellenleiter LWL zugeordnet ist. Auf diese Weise ergibt sich eine Vielfach- Laserlichtquelle, die mit nur einem Element zugleich alle Teil lichtquellen synchron durchzustimmen gestattet. Wegen der Einkopplung in Lichtwellenleiter LWL kann die Laserstrahlung zugleich an relativ weit voneinander entfernte Orte geleitet werden. Diese Eigenschaft kann besonders für die Raman-Spektroskopie von Vorteil sein, zumal bereits Raman-Spektrometer verfügbar sind, die mehrere Spektren zugleich aufnehmen können, wobei die Ramanstrahlung in der Regel über Lichtwellenleiter LWL zum Spektrometer geführt wird.

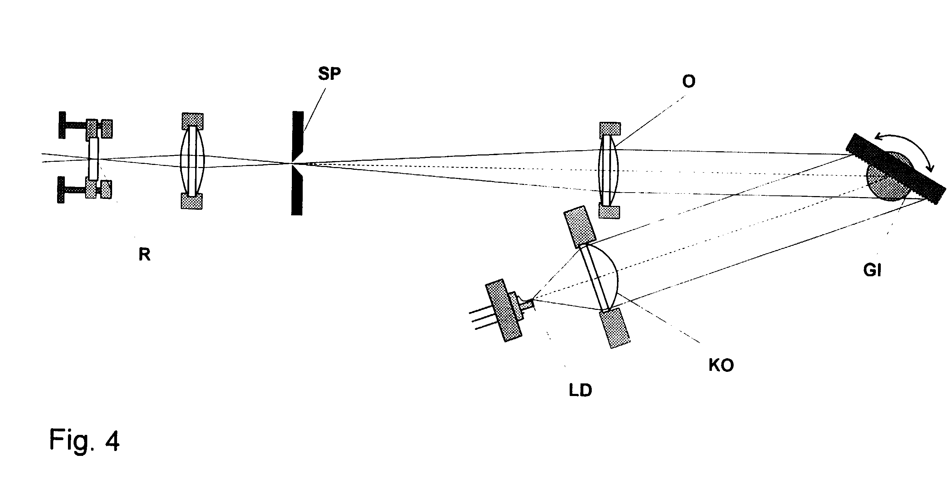

Unter Umständen kann es vorteilhaft sein, das Raumfilter SP räumlich getrennt vom Reflektor R anzuordnen. In diesem Fall kann in Strahlrichtung gesehen hinter dem Raumfilter SP eine Abbildung des Raumfilters SP erfolgen, wobei der Reflektor R am Ort der Abbildung des Raumfilters SP angeordnet wird. Ein Beispiel für dieses Prinzip ist in Fig. 4 dargestellt.

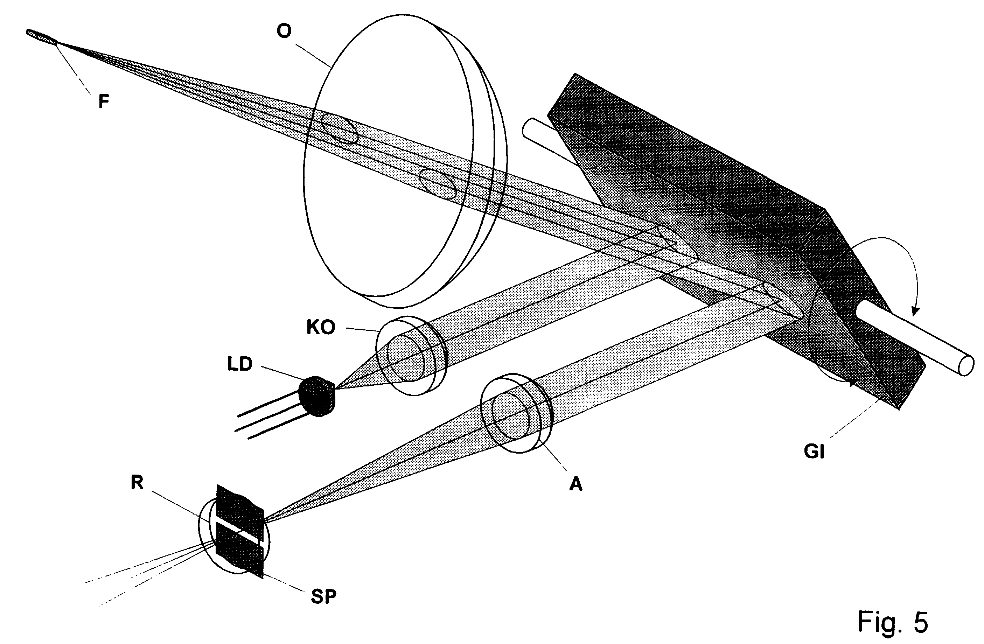

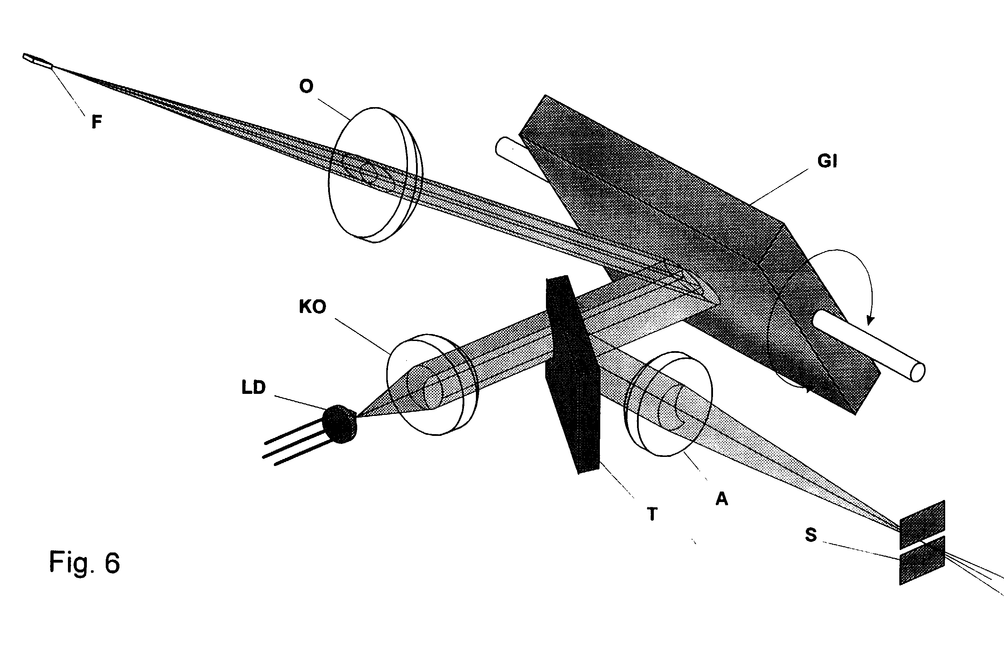

Eine weitere Variante der Erfindung (Fig. 5) hat eine nochmalige Reduzierung der ausgekoppelten Lumineszenz und Nebenmoden zum Inhalt.
Die im vorliegenden Fall von der einseitig entspiegelten Laserdiode LD ausgehende, vom Kollimator KO weitgehend in ein paralleles Bündel überführte Strahlung wird ein erstes Mal vom Gitter GI gebeugt und gelangt in die Optik O, und zwar parallel versetzt zu deren optischer Achse. Die Optik O entwirft ein vorzugsweise beugungsbegrenztes Bild um deren Brennpunkt herum. An diesem Ort ist eine in Dispersionsrichtung schmale, hochreflektierende, ebene Facette angeordnet, die zugleich als ein erstes Raumfilter und als ein erster Reflektor wirkt. Die von dieser Facette reflektierte Strahlung eines schmalen Wellenlängenbereiches gelangt nochmals in die Optik O, und zwar im Vergleich zum hinlaufenden Strahlenbündel entsprechend entgegengesetzt verschoben zu deren optischer Achse. Die Strahlung wird daraufhin ein zweites Mal am Gitter GI gebeugt und gelangt in eine Abbildungsoptik A, die ihrerseits ein beugungsbegrenztes Bild der Laserfacette LD auf dem teildurchlässigen Reflektor R entwirft. Das im wesentlichen in derselben Ebene wie der Reflektor R angeordnete, als Spalt ausgeführte Raumfilter SP sperrt nochmals Strahlung außerhalb des gewählten Wellenlängenintervalls. Da der Reflektor teildurchlässig ausgeführt ist, durchläuft ein Teil der selektierten Strahlung den bisherigen Strahlengang noch einmal in entgegengesetzter Richtung und wird mit hoher Stabilität in die Laserdiode LD rückgekoppelt.
Der Vorteil dieser Ausführungsform gegenüber der Grundvariante besteht vor allem darin, daß die Strahlung vor der Auskopplung das Gitter zweimal an verschiedenen Stellen durchläuft und damit der ausgekoppelte Anteil des zwar sehr geringen, aber nicht vermeidbaren Streulichtes vom Gitter drastisch reduziert wird. Die Facette F wirkt zudem für den zweiten Durchlauf als definierter Eintrittsspalt. Zweckmäßig wird diese als stabiles Profil (z.B: H-Form) in einem Hohlraum, dessen Wände weitestgehend schwarz sind und keinen Ramaneffekt zeigen, angeordnet. Es ist sinnvoll, den Strahlengang von der Laserdiode LD und den Strahlengang zum Reflektor R durch eine Blendenanordnung gegeneinander abzuschirmen, damit möglichst wenig Streulicht, u.a. vom Gitter, in den Spalt SP gelangt.
Da die wieder in die Laserdiode LD rückgekoppelte Strahlung das Gitter insgesamt viermal durchläuft, ist die verfügbare Strahlungsleistung etwas geringer als bei der Grundvariante. Weil aber Gitter mit sehr hoher Beugungseffektivität zur Verfügung stehen, ist dieser Verlust an Leistung nicht wesentlich.
Eine Abwandlung dieser Variante zeigt Fig. 6. Im Unterschied zu dieser trifft das Strahlenbündel mit seiner Mittelachse nach erstmaliger Beugung am Gitter GI die Optik O nur wenig außerhalb der optischen Achse, so daß sich dieses Bündel mit dem von der Facette F reflektierten überlappt. Das vom Gitter GI abermals gebeugte Strahlenbündel überlappt sich wiederum mit dem von der Laserdiode LD ausgegangenen. Auf diese Weise kann der vom Gitter zum zweiten Mal gebeugte, sich mit dem hingehenden Bündel überlappende Strahlungsanteil unmittelbar zur Rückkopplung in die Laserdiode verwendet werden, andererseits der nicht überlappende Anteil des zum zweiten Mal am Gitter GI gebeugten Bündels durch einen Spiegel T ausgeblendet werden. Die derart aus dem Resonator geführte Strahlung gelangt in eine Abbildungsoptik A, in deren Brennebene sich der Austrittsspalt SP befindet. An diesem Ort steht die nutzbare Strahlung zur Verfügung, nachdem sie wie im vorangegangenen Beispiel (Fig. 5) zweimal das Gitter GI durchlaufen hat.

Ein weiteres Ausführungsbeispiel beinhaltet eine nochmalige Vereinfachung der Anordnung, wobei gleichzeitig eine Verkürzung der wirksamen Resonatorlänge erreicht wird. Hierbei entfällt in einer ersten Ausführungsform die abbildende Optik O. Ihre Funktion wird mit vom Beugungsgitter GI übernommen, das hierfür als abbildendes Gitter mit im benutzten Wellenlängenbereich weitestgehend beugungsbegrenzter Abbildungsqualität ausgeführt ist. In einer weiteren Ausführungsform ist das abbildende Gitter GI so ausgelegt, daß es auch die Aufgabe des Kollimators KO übernimmt.

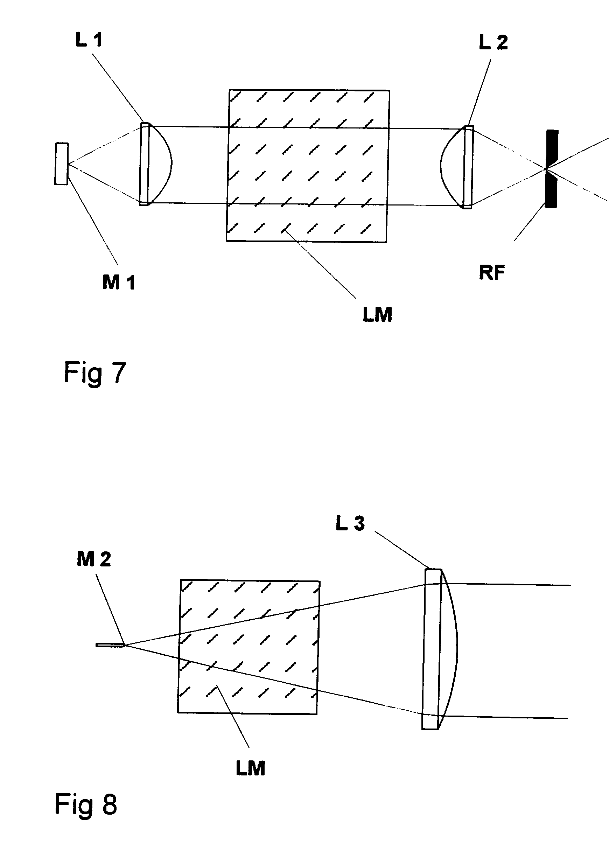

Die Anwendbarkeit der Erfindung ist nicht auf Halbleiterlaseranordnungen beschränkt.
An Stelle der einseitig entspiegelten Laserdiode kann ein anderes geeignetes Lasermedium, z.B. ein Farbstoff mit entsprechender Pumpquelle und einem Resonatorendspiegel, verwendet werden, dessen Strahlengang z.B.in einen Spalt abgebildet wird. Fig. 7 zeigt ein mögliches Prinzip: Als Resonatorendspiegel dient ein Retroreflektor, der aus einer sammelnden Optik L 1 und einem Spiegel M 1 besteht. Eine weitere sammelnde Optik L 2 bildet den parallelen Strahlengang in ein Raumfilter ab. Zwischen den beiden sammelnden Optiken L 1, L 2 befindet sich das Lasermedium LM. Eine derartige Anordnung kann an Stelle einer Laserdiode in der erfindungsgemäßen Laserlichtquelle verwendet werden, wobei das Raumfilter RF die Rolle der Austrittsfacette der einseitig entspiegelten Laserdiode spielt.
Ein weiteres Beispiel zeigt Fig. 8. Hierbei spielt die sammelnde Optik L 3 die Rolle des Kollimators KO aus Fig. 2 bis 6. Ein vorzugsweise ebener Spiegel, der in Dispersionsrichtung des dispergierenden Elementes GI (Fig. 2 bis 6) vorzugsweise nur eine geringe Ausdehnung hat und in der Brennebene der sammelnden Optik L 3 steht, bildet mit dieser zusammen einen Retroreflektor. Durch Anordnung des Lasermediums LM im Strahlengang und Anordnung eines geeigneten Pumpmechanismus wird die Laserlichtquelle vervollständigt. Da hierbei die definierte Austrittsfacette in Form eines Raumfilters RF oder zumindest der optisch wirksamen Austrittsfacette einer Laserdiode fehlt, ist hierfür besonders ein Aufbau nach Fig. 5 oder nach Fig. 6 geeignet.

Die Erfindung ist nicht auf die hier beschriebenen Ausführungsbeispiele beschränkt. Vielmehr ist es möglich, durch Kombination der Merkmale weitere Ausführungsvarianten zu realisieren, ohne den Rahmen der Erfindung zu verlassen.

## Patentansprüche

1. Durchstimmbare Laserlichtquelle, im wesentlichen bestehend aus dem Lasermedium (LD) einschließlich einem Resonatorendspiegel, einem abbildenden System (KO, O), einem winkeldispergierenden Element (GI) und einem teildurchlässig ausgebildeten Reflektor (R),
dadurch gekennzeichnet,
daß der am Ort des durch das abbildende System (KO, O) gegebeben Fokus der Laserstrahlung befindliche teildurchlässig ausgebildete Reflektor (R) derart angeordnet ist, daß er zusammen mit zumindest einem Teil (O) des abbildenden Systems einen weitgehend richtungsunabhängigen Retroreflektor nach dem Katzenaugen-Prinzip bildet und sich zugleich wenigstens näherungsweise in der Ebene des Reflektors (R) auch ein in Dispersionsrichtung des winkeldispergierenden Elementes (GI) spaltförmiges Raumfilter (SP) oder dessen Bild befindet, wobei sich die Spaltbreite in Dispersionsrichtung erstreckt, so daß nur spektral gefilterte Strahlung das Raumfilter (SP) passieren kann, dadurch nur diese auf den Reflektor (R) gelangt und hier die Trennung von rückgekoppelter und ausgekoppelter, nutzbarer Strahlung bei hoher Stabilität gegen Dejustierungen der Bauteile senkrecht zur Dispersionsrichtung des winkeldispergierenden Elementes (GI) und Kippung des Reflektors (R) erfolgt.

2. Durchstimmbare Laserlichtquelle, im wesentlichen bestehend aus dem Lasermedium (LD) einschließlich einem Resonatorendspiegel, einem winkeldispergierenden Element (GI), einem abbildenden System und zwei Reflektoren (F,R),
dadurch gekennzeichnet,
daß in der Laserlichtquelle zwei Retroreflektoren (O, F; A, R) nach dem Katzenaugen-Prinzip,jeweils gebildet aus einer sammelnden Optik (O, A) und einem der Reflektoren (F, R) in deren Brennebene, angeordnet sind, weiterhin optische Mittel angeordnet sind, die die vom Lasermedium ausgehende Strahlung als paralleles Bündel auf das dispergierende Element (GI) leiten, die optische Achse dieser Mittel parallel zur optischen Achse des zweiten Retroreflektors (A, R) angeordnet ist, diese beiden optischen Achsen nach dem Durchlaufen des dispergierenden Elementes (GI) den ersten Retroreflektor (O, F) symmetrisch und parallel zu dessen optischer Achse treffen, zugleich der zum ersten Retroreflektor (O, F) gehörende Reflektor (F) in Dispersionsrichtung des dispergierenden Elementes (GI) nur eine geringe Ausdehnung besitzt, dadurch von diesem nur ein schmaler Wellenlängenbereich der vom dispergierenden Element (GI) dispergierten Strahlung reflektiert wird und zugleich unmittelbar vor dem Reflektor (R) des zweiten Retroreflektors (A, R) ein spaltförmiges Raumfilter (SP) angeordnet ist, das in Dispersionsrichtung des dispergierenden Elementes (GI) ebenfalls nur in geringer geometrischer Ausdehnung durchlässig ist, so daß abermals nur ein schmaler Wellenlängenbereich der bis dahin gelangten Strahlung das Raumfilter (SP) passieren kann und schließlich der zugehörige Reflektor (R) teildurchlässig ausgebildet ist, so daß an dieser Stelle zum einen die durch zweimalige Dispersion gefilterte Strahlung aus dem Resonator geführt wird und zum anderen der reflektierte Anteil der gefilterten Strahlung auf dem umgekehrten Wege wieder in das Lasermedium (LD) rückgekoppelt wird.

3. Durchstimmbare Laserlichtquelle, im wesentlichen bestehend aus dem Lasermedium einschließlich einem Resonatorendspiegel, einem winkeldispergierenden Element (GI), einem abbildenden System und zwei Reflektoren (F,T),
dadurch gekennzeichnet,
daß in der Laserlichtquelle ein Retroreflektor (O, F) nach dem Katzenaugen-Prinzip, gebildet aus einer sammelnden Optik (O) und einem Reflektor (F) in deren Brennebene, angeordnet ist, weiterhin optische Mittel angeordnet sind, die die vom Lasermedium ausgehende Strahlung als paralleles Bündel auf das dispergierende Element (GI) leiten, die optische Achse dieser Mittel nach dem Durchlaufen des dispergierenden Elementes (GI) den Retroreflektor (O, F) parallel versetzt zu dessen optischer Achse trifft, wobei der zum Retroreflektor (O, F) gehörende Reflektor (F) in Dispersionsrichtung des dispergierenden Elementes (GI) nur eine geringe Ausdehnung besitzt, dadurch von diesem nur ein schmaler Wellenlängenbereich der vom dispergierenden Element (GI) dispergierten Strahlung reflektiert wird, wobei sich die durch die sammelnde Optik (O) hin- und rücklaufenden Bündel teilweise überlappen, dadurch auch innerhalb des vom Lasermedium ausgehenden Bündelquerschnitts ein Teil des vom dispergierenden Element (GI) zum zweiten Mal dispergierten Strahlungsbündels in das Lasermedium zurücktrifft und zugleich im wesentlichen der nichtüberlappende Teil des vom dispergierenden Element zum zweiten Mal dispergierten Strahlungsbündels über einen Spiegel (T) in eine sammelnde Optik (A) mit einem in ihrer Brennebene angeordneten spaltförmigen Raumfilter (S), das in Dispersionsrichtung des dispergierenden Elementes nur in einer geometrisch geringen Ausdehnung durchlässig ist, geleitet wird, so daß an dieser Stelle nochmals nur ein schmaler Wellenlängenbereich der bis dahin gelangten Strahlung als nutzbare Strahlung aus dem Resonator geführt wird.

4. Durchstimmbare Laserlichtquelle nach einem der Ansprüche 1 bis 3,
dadurch gekennzeichnet,
daß das dispergierende Element (GI) ganz oder teilweise auch die Funktion des abbildenden Systems übernimmt.

5. Durchstimmbare Laserlichtquelle nach mindestens einem der Ansprüche 1 oder 2,
dadurch gekennzeichnet,
daß als Reflektor (R) die teilreflektierende Stirnfläche eines Lichtwellenleiters (LWL) dient und damit die nutzbare, spektral gefilterte Laserleistung an dessen Ausgang zur Verfügung steht.

6. Durchstimmbare Laserlichtquelle nach einem der Ansprüche 1 oder 2,
dadurch gekennzeichnet,
daß als Reflektor (R) die teilreflektierende, nicht notwendig erste Fläche einer Auskoppeloptik (L) dient.

7. Durchstimmbare Laserlichtquelle nach einem der Ansprüche 1 bis 3,
dadurch gekennzeichnet,
daß das dispergierende Element (GI) ein Beugungsgitter ist.

8. Durchstimmbare Laserlichtquelle nach Anspruch 7,
dadurch gekennzeichnet,
daß in Strahlrichtung gesehen vor dem Beugungsgitter (GI) ein 90-Grad Polarisationsdreher (PD) angeordnet ist, um abhängig von der Polarisationsrichtung der Laserstrahlung das Beugungsgitter (GI) bei höchster Beugungseffektivität zu benutzen, wobei die in das Lasermedium (LD) rückgekoppelte Strahlung dieses wieder in der ursprünglichen Polarisationsrichtung trifft.

9. Durchstimmbare Laserlichtquelle nach einem der Ansprüche 1 bis 3,
dadurch gekennzeichnet,
daß als Lasermedium (LD) ein Halbleiterlaser dient.

10. Durchstimmbare Laserlichtquelle nach Anspruch 9,
dadurch gekennzeichnet,
daß die Austrittsfacette des Halbleiterlasers weitgehend entspiegelt ist.

11. Durchstimmbare Laserlichtquelle nach einem der Ansprüche 1 bis 3,
dadurch gekennzeichnet,
daß als Lasermedium (LD) eine Zeile von Halbleiterlasern dient.

12. Durchstimmbare Laserlichtquelle nach Anspruch 11,
dadurch gekennzeichnet,
daß sich am Ort jedes Einzellaserbildes die teilreflektierende Eintrittsfacette je eines Lichtwellenleiters befindet, derart, daß damit mehrere, synchron durchstimmbare Laserlichtquellen zur Verfügung stehen und daß damit die Strahlung der Einzellaserlichtquellen zugleich an relativ weit voneinander entfernte Orte geleitet werden kann.

13. Durchstimmbare Laserlichtquelle nach einem der Ansprüche 1 bis 3,
dadurch gekennzeichnet,
daß zwischen dem Lasermedium (LD) und dem dispergierenden Element (GI) ein Kollimator (KO) angeordnet ist.

14. Laserlichtquelle nach einem der Ansprüche 1 bis 3,
dadurch gekennzeichnet,
daß als Lasermedium einschließlich einem Resonatorendspiegel ein Aufbau, bestehend aus einem Resonatorendspiegel bzw. einem Retroreflektor (L 1, M1), dem Lasermedium (LM) sowie einer Optik (L 2) und einem Raumfilter in deren Brennebene vorhanden ist, und dieser Aufbau mit seinem Raumfilter wie die Austrittsfacette einer Laserdiode angeordnet ist.

15. Laserlichtquelle nach einem der Ansprüche 1 bis 3,
dadurch gekennzeichnet,
daß in der rückwärtigen Brennebene der Optik KO an Stelle der Austrittsfacette einer Laserdiode ein Resonatorendspiegel angeordnet ist und sich das Lasermedium an einer beliebigen Stelle zwischen diesem Resonatorendspiegel (M 2) und dem dispergierenden Element (GI) befindet.

16. Laserlichtquelle nach Anspruch 15,
dadurch gekennzeichnet,
daß der Resonatorendspiegel (M 2) in Dispersionsrichtung des dispergierenden Elementes (GI) nur eine geometrisch geringe Ausdehnung besitzt.

17. Verfahren zur Gewinnung spektral gefilterter Laserstrahlung zur Auskopplung aus und zugleich Rückkopplung in einen Laserresonator, wobei das vom Lasermedium einschließlich einem Resonatorendspiegel ausgehende Strahlenbündel quer zu seiner Ausbreitungsrichtung winkeldispergiert wird, dann fokussiert wird, im Fokus oder dessen Nähe derart gefiltert wird, daß nur ein schmaler Wellenlängenbereich der Strahlung weitergelangt, dabei eine Reflexion des nicht hindurchgelassenen Anteils der Strahlung zurück in den Resonator weitestgehend verhindert wird und schließlich nach der Filterung ebenfalls im Fokus oder einer Abbildung dieses Fokus durch einen teildurchlässig ausgebildeten Reflektor ein Teil der Strahlung in den Laserresonator reflektiert, ein anderer Teil zur Nutzung der Laserstrahlung hindurchgelassen wird,
dadurch gekennzeichnet,
daß nach der Fokussierung der Laserstrahlung die Filterung im Fokus oder einer Abbildung dieses Fokus geschieht und die Reflexion im Zusammenhang mit der Fokussierung senkrecht zur Dispersionsrichtung nach dem Prinzip eines weitgehend richtungsunabhängigen Retroreflektors nach dem Katzenaugenprinzip erfolgt.

18. Verfahren zur Gewinnung spektral gefilterter Laserstrahlung zur Auskopplung aus und zugleich Rückkopplung in einen Laserresonator,
dadurch gekennzeichnet,
daß das vom Lasermedium einschließlich einem Resonatorendspiegel ausgehende Strahlenbündel quer zu seiner Ausbreitungsrichtung dispergiert sowie fokussiert wird, im Fokus oder dessen Nähe derart gefiltert und zugleich reflektiert wird, daß nur ein schmaler Wellenlängenbereich der Strahlung zurückläuft, wobei Fokussierung und Reflexion zusammen nach dem Prinzip eines weitgehend richtungsunabhängigen Retroreflektors nach dem Katzenaugenprinzip erfolgen, dabei hin- und rücklaufendes Strahlenbündel gegeneinander parallel versetzt sind, aber durch dasselbe Bauteil laufen, ein zweites Mal an demselben Bauteil wie das erste Mal dispergiert wird, wieder fokussiert wird, im Fokus oder dessen Nähe derart durch ein spaltförmiges Raumfilter räumlich gefiltert wird, daß nur ein schmaler Wellenlängenbereich der Strahlung weitergelangt, und schließlich nach der Filterung ebenfalls im Fokus oder einer Abbildung dieses Fokus eine Teilreflexion an einem teildurchlässig ausgebildeten Reflektor erfolgt, so daß ein Teil der Strahlung über denselben Weg zum Lasermedium zurückläuft und ein anderer Teil zur Nutzung der Laserstrahlung hindurchgelassen wird.

19. Verfahren nach einem der Ansprüche 17 oder 18,
dadurch gekennzeichnet,
daß die Trennung von rückgekoppelter und ausgekoppelter Strahlung an einer einzigen Fläche erfolgt.

20. Verfahren zur Gewinnung spektral gefilterter Laserstrahlung zur Auskopplung aus und zugleich Rückkopplung in einen Laserresonator,
dadurch gekennzeichnet,
daß das vom Lasermedium einschließlich einem Resonatorendspiegel ausgehende Strahlenbündel quer zu seiner Ausbreitungsrichtung dispergiert sowie fokussiert wird, im Fokus oder dessen Nähe derart gefiltert und zugleich reflektiert wird, daß nur ein schmaler Wellenlängenbereich der Strahlung zurückläuft, wobei Fokussierung und Reflexion zusammen nach dem Prinzip eines weitgehend richtungsunabhängigen Retroreflektors nach dem Katzenaugenprinzip erfolgen, dabei hin- und rücklaufendes Strahlenbündel gegeneinander derart parallel versetzt sind, daß sie sich teilweise überlappen, ein zweites Mal an demselben Bauteil wie das erste Mal dispergiert wird, der nicht überlappende Strahlenbündelanteil abgetrennt und wieder fokussiert wird, im Fokus oder dessen Nähe durch ein spaltförmiges Raumfilter räumlich derart gefiltert wird, daß nur ein schmaler Wellenlängenbereich der Strahlung den Laserresonator zur Nutzung der Laserstrahlung verläßt, dagegen der überlappende Strahlenbündelanteil wieder in das Lasermedium gelangt.

## Claims

1. A tunable laser light source, essentially consisting of a laser medium (LD), and including a resonator terminal mirror, an imaging system (KO, O), an angular-dispersing element (GI), and a reflector (R) designed so as to be partially transmitting,
characterized in that
the reflector (R) situated at the site of the focus of the laser radiation defined by said imaging system (KO, O) and designed so as to be partially transmitting is arranged in such a fashion that together with at least a part (O) of the imaging system, it forms a largely direction-independent retroreflector according to the cat's eye principle, and at the same time, a space filter (SP) or an image thereof, slit-shaped in dispersion direction of the angular-dispersing element (GI), is situated at least approximately in the plane of reflector (R), the slit width extending in dispersion direction, so that only spectrally filtered radiation may pass the space filter (SP), thereby reaching the reflector (R), and the separation of back-coupled and decoupled, usable radiation is effected there, with high stability against maladjustment of the components vertically to the dispersion direction of the angular-dispersing element (GI) and against inclination of the reflector (R).

2. A tunable laser light source, essentially consisting of said laser medium (LD), and including a resonator terminal mirror, an angular-dispersing element (GI), an imaging system, and two reflectors (F, R),
characterized in that
in said laser light source, two retroreflectors (O, F; A, R) according to the cat's eye principle, each one constituted of a converging lens (O, A) and one of said reflectors (F, R), are arranged in the focal plane thereof, and in addition, optical means are arranged conducting the radiation emitted by the laser medium as a parallel beam to the dispersing element (GI), the optical axis of said means is arranged parallel to the optical axis of the second retroreflector (A, R), these two optical axes, after passing said dispersing element (GI), reach the first retroreflector (O, F) symmetrically and parallel to the optical axis thereof, and at the same time, the reflector (F) pertaining to the first retroreflector (O, F) is small in size with respect to the dispersion direction of the dispersing element (GI), so that only a narrow wavelength range of the radiation dispersed by the dispersing element (GI) is reflected therefrom, and at the same time, a slit-shaped space filter (SP) is arranged immediately before the reflector (R) of the second retroreflector (A, R), which filter likewise has transmittance in only a small geometrical dimension in the dispersion direction of the dispersing element (GI), so that again, only a narrow wavelength range of radiation having reached that far may pass the space filter (SP), and finally, the pertaining reflector (R) is designed so as to be partially transmitting, so that at this site, the radiation filtered by double dispersion is conducted out of the resonator on the one hand, and on the other hand, the reflected fraction of the filtered radiation is coupled back into the laser medium (LD) on the reverse way.

3. A tunable laser light source, essentially consisting of a laser medium, and including a resonator terminal mirror, an angular-dispersing element (GI), an imaging system, and two reflectors (F, T),
characterized in that
in said laser light source, a retroreflector (O, F) according to the cat's eye principle, constituted of a converging lens (O) and a reflector (F) is arranged in the focal plane thereof, and in addition, optical means are arranged conducting the radiation emitted by the laser medium as a parallel beam to the dispersing element (GI), the optical axis of said means, after passing said dispersing element (GI), reaches the retroreflector (O, F) in parallel displacement relative to the optical axis thereof, the reflector (F) pertaining to said retroreflector (O, F) being small in size with respect to the dispersion direction of the dispersing element (GI), so that only a narrow wavelength range of the radiation dispersed by the dispersing element (GI) is reflected, the beams passing through the converging lens (O) in forward and reverse directions overlapping partially, so that also within the beam cross section emitted by the laser medium, a fraction of the beam dispersed a second time by said dispersing element (GI) strikes the laser medium again, and at the same time, essentially the nonoverlapping fraction of the beam dispersed a second time by the dispersing element is passed via mirror (T) to a converging lens (A) having a slit-shaped space filter (S) arranged in the focal plane thereof, which filter has transmittance in only a small geometrical dimension in the dispersion direction of the dispersing element, so that at this site again, only a narrow wavelength range of radiation having reached that far is conducted out of the resonator as usable radiation.

4. The tunable laser light source according to one of claims 1 to 3,
characterized in that
the dispersing element (GI) completely or partially takes over the function of the imaging system as well.

5. The tunable laser light source according to at least one of claims 1 or 2,
characterized in that
the partially reflecting front surface of an optical waveguide (LWL) serves as reflector (R), so that the usable, spectrally filtered laser power is available at the exit thereof.

6. The tunable laser light source according to at least one of claims 1 or 2,
characterized in that
the partially reflecting, not necessarily first surface of a decoupling lens (L) serves as reflector (R).

7. The tunable laser light source according to one of claims 1 to 3,
characterized in that
the dispersing element (GI) is a diffraction grating.

8. The tunable laser light source according to claim 7,
characterized in that
a 90° polarization rotator (PD) is arranged before the diffraction grating (GI) as viewed in beam direction, in order to use the diffraction grating (GI) at maximum diffraction efficiency in dependence of the polarization direction of the laser radiation, the radiation coupled back into the laser medium (LD) striking same in the original direction of polarization.

9. The tunable laser light source according to one of claims 1 to 3,
characterized in that
a semiconductor laser serves as laser medium (LD).

10. The tunable laser light source according to claim 9,
characterized in that
the exit facet of the semiconductor laser is substantially dereflected.

11. The tunable laser light source according to one of claims 1 to 3,
characterized in that
a line of semiconductor lasers serves as laser medium (LD).

12. The tunable laser light source according to claim 11,
characterized in that
the partially reflecting entrance facet of an optical waveguide is present at the site of each single laser image, so that multiple, synchronously tunable laser light sources are provided and thus, the radiation of these single laser light sources may be conveyed simultaneously to sites relatively far apart from each other.

13. The tunable laser light source according to one of claims 1 to 3,
characterized in that
a collimator (KO) is arranged between the laser medium (LD) and the dispersing element (GI).

14. The laser light source according to one of claims 1 to 3,
characterized in that
a configuration consisting of a resonator terminal mirror or a retroreflector (L1, M1), the laser medium (LM), a lens (L2) and a space filter in the focal plane thereof is present as laser medium including said resonator terminal mirror, and said configuration with its space filter is arranged like the exit facet of a laser diode.

15. The laser light source according to one of claims 1 to 3,
characterized in that
a resonator terminal mirror is arranged in the rear focal plane of lens KO instead of the exit facet of a laser diode, and the laser medium may be at any position between said resonator terminal mirror (M2) and the dispersing element (GI).

16. The laser light source according to claim 15,
characterized in that
the resonator terminal mirror (M2) has only small geometrical dimensions in the dispersion direction of the dispersing element (GI).

17. A method for obtaining spectrally filtered laser radiation for decoupling from and simultaneously back-coupling into a laser resonator, wherein the beam emitted by the laser medium including a resonator terminal mirror is angular-dispersed across its direction of propagation, then focussed, filtered in the focus or the proximity thereof in such a way that only a narrow wavelength range of the radiation is passed on, reflection of the non-transmitted fraction of radiation back into the resonator being substantially prevented, and eventually, after filtering also effected in the focus or an image of the focus, a fraction of the radiation is reflected into the laser resonator through a reflector designed so as to be partially transmitting, and another fraction is transmitted in order to use the laser radiation,
characterized in that
subsequent to focussing the laser radiation, filtering takes place in the focus or an image of the focus, and reflection in association with said focussing is effected vertically to the dispersion direction, according to the principle of a largely direction-independent retroreflector according to the cat's eye principle.

18. A method for obtaining spectrally filtered laser radiation for decoupling from and simultaneously back-coupling into a laser resonator,
characterized in that
the beam emitted by the laser medium including a resonator terminal mirror is dispersed across its direction of propagation and focussed, filtered and simultaneously reflected in the focus or the proximity thereof in such a way that only a narrow wavelength range of the radiation is returned, focussing and reflection being effected together according to the principle of a largely direction-independent retroreflector according to the cat's eye principle, forward and reverse beams being displaced parallel to each other but passing the same element, dispersion being effected a second time at the same element as in the first time, focussing is effected again, spatial filtering through a slit-shaped space filter is effected in the focus or the proximity thereof in such a way that only a narrow wavelength range of the radiation is passed on and eventually, after filtering also effected in the focus or an image of the focus, partial reflection takes place at a reflector designed so as to be partially transmitting, so that a fraction of the radiation returns to the laser medium on the same path, and another fraction is transmitted in order to use the laser radiation.

19. The method according to one of claims 17 or 18,
characterized in that
the separation of the back-coupled and decoupled radiation is effected at one single surface.

20. A method for obtaining spectrally filtered laser radiation for decoupling from and simultaneously back-coupling into a laser resonator,
characterized in that
the beam emitted by the laser medium including a resonator terminal mirror is dispersed across its direction of propagation and focussed, filtered and simultaneously reflected in the focus or the proximity thereof in such a way that only a narrow wavelength range of the radiation is returned, focussing and reflection being effected together according to the principle of a largely direction-independent retroreflector according to the cat's eye principle, forward and reverse beams being displaced parallel to each other so as to partially overlap each other, dispersion being effected a second time at the same element as in the first time, the nonoverlapping beam fraction is separated and refocussed, spatial filtering through a slit-shaped space filter is effected in the focus or the proximity thereof in such a way that only a narrow wavelength range of the radiation issues from the laser resonator for use of the laser radiation, while the overlapping beam fraction returns into the laser medium.

## Revendications

1. Source laser lumineuse à fréquence variable, constituée essentiellement d'un générateur laser (LD) comprenant un miroir terminal de cavité, un système de formation d'image (KO, O), un élément angulaire disperseur (GI) et un réflecteur (R) formé de manière à être partiellement perméable,
**caractérisée en ce que**
le réflecteur formé de manière à être partiellement perméable (R) situé à l'emplacement du foyer de rayon laser donné par le système de formation d'image (KO, O) est placé de manière à former avec au moins une partie (O) du système d'image un rétroréflecteur largement indépendant de la direction, suivant le principe d'un oeil de chat, et en ce qu'il se trouve aussi simultanément au moins approximativement dans le plan du réflecteur (R) un filtre de fréquences spatiales (SP) en forme de fente, ou l'image de celui-ci, dans le sens de dispersion de l'élément angulaire disperseur (GI), la largeur de fente s'étendant dans le sens de dispersion, de sorte que seul un rayon à spectre filtré peut passer au travers du filtre de fréquences spatiales (SP), étant par là seul à parvenir sur le réflecteur (R), et que la séparation de rayonnement rétroactif, déclenché et utile y est effectuée avec une haute stabilité contre des désajustements de composants, perpendiculairement au sens de dispersion de l'élément angulaire disperseur (GI) et de basculement du réflecteur (R).

2. Source laser lumineuse à fréquence variable, constituée essentiellement d'un générateur laser (LD) comprenant un miroir terminal de cavité, un élément angulaire disperseur (GI), un système de formation d'image et deux réflecteurs (F, R),
**caractérisée en ce que**
deux rétroréflecteurs (O, F; A, R) sont disposés dans la source laser lumineuse suivant le principe d'un oeil de chat, formés chacun d'un objectif concentrateur (O, A) et d'un des réflecteurs (F, R) dans le plan focal de celui-ci; que d'autres moyens optiques sont disposés conduisant le rayon partant du générateur laser comme pinceau parallèle sur l'élément disperseur (GI), que l'axe optique de ces moyens est parallèle à l'axe optique du second rétroréflecteur (A, R), que ces deux axes optiques après traversée de l'élément disperseur (GI) touchent le premier rétroréflecteur (O, F) symétriquement et parallèlement à l'axe optique de ce dernier, que le réflecteur (F) du premier rétroréflecteur (O, F) ne présente qu'une dimension réduite dans le sens de dispersion de l'élément disperseur (GI), ce par quoi il ne réfléchit qu'une bande étroite de longueurs d'ondes du rayon dispersé par l'élément disperseur (GI), et qu'un filtre de fréquences spatiales (SP) en forme de fente est placé immédiatement devant le réflecteur (R) du second rétroréflecteur (A, R), ledit filtre de fréquences spatiales n'étant également perméable que sur une extension géométrique réduite dans le sens de dispersion de l'élément disperseur (GI), de sorte que seule une bande étroite de longueurs d'ondes du rayon parvenu jusque là peut passer au travers du filtre de fréquences spatiales (SP), et que le réflecteur associé (R) est finalement formé de manière à être partiellement perméable, de sorte qu'à cet endroit le rayon filtré par double dispersion est conduit hors du miroir d'une part, et que la part réfléchie du rayon filtré est rétroactivée en sens inverse sur le générateur laser (LD), d'autre part.

3. Source laser lumineuse à fréquence variable, constituée essentiellement d'un générateur laser comprenant un miroir terminal de cavité, un élément angulaire disperseur (GI), un système de formation d'image et deux réflecteurs (F, T),
**caractérisée en ce qu'**
un rétroréflecteur (O, F) est disposé dans la source laser lumineuse suivant le principe d'un oeil de chat, formé d'un objectif concentrateur (O) et d'un réflecteur (F) dans le plan focal de celui-ci; que d'autres moyens optiques sont disposés conduisant le rayon partant du générateur laser comme pinceau parallèle sur l'élément disperseur (GI), que l'axe optique de ces moyens touche le rétroréflecteur (O, F) après traversée de l'élément disperseur (GI), cet axe étant décalé parallèlement par rapport à l'axe optique de ce dernier, le réflecteur (F) du rétroréflecteur (O, F) ne présentant qu'une dimension réduite dans le sens de dispersion de l'élément disperseur (GI), ce par quoi il ne réfléchit qu'une bande étroite de longueurs d'ondes du rayon dispersé par l'élément disperseur (GI), les pinceaux traversant dans un sens et en sens inverse l'objectif concentrateur (O) se recouvrant partiellement, ce par quoi aussi une partie du pinceau de rayon dispersé pour la seconde fois par l'élément de dispersion (GI) retourne toucher le générateur laser à l'intérieur de la section de pinceau partant du générateur laser, et la partie non recouvrante du pinceau de rayon dispersé pour la seconde fois par l'élément de dispersion est pour l'essentiel conduite par miroir (T) sur un objectif concentrateur (A) à filtre de fréquences spatiales (S) en forme de fente disposé dans le plan focal de l'objectif, ledit filtre de fréquences spatiales n'étant perméable que sur une extension géométriquement réduite dans le sens de dispersion de l'élément de dispersion, de sorte qu'à cet endroit, encore une fois, seule une bande étroite de longueurs d'ondes du rayon parvenu jusque là peut être conduite hors du miroir en tant que rayon utile.

4. Source laser lumineuse à fréquence variable selon l'une des revendications 1 à 3,
**caractérisée en ce que**
l'élément de dispersion (GI) assume aussi la fonction du système de formation d'image, totalement ou en partie.

5. Source laser lumineuse à fréquence variable selon l'une des revendications 1 ou 2 au moins,
**caractérisée en ce en que**
la face antérieure partiellement réfléchissante d'un guide d'ondes lumineuses (LWL) sert de réflecteur (R) et donc que l'intensité utile, à spectre filtré du laser est disponible à sa sortie.

6. Source laser lumineuse à fréquence variable selon l'une des revendications 1 ou 2,
**caractérisée en ce que**
la première surface partiellement réfléchissante et non nécessaire d'un objectif de déclenchement (L) sert de réflecteur (R).

7. Source laser lumineuse à fréquence variable selon l'une des revendications 1 à 3,
**caractérisée en ce que**
l'élément de dispersion (GI) est une grille de diffraction.

8. Source laser lumineuse à fréquence variable selon revendication 7,
**caractérisée en ce qu'**
un inverseur de polarisation (PD) à 90° est disposé dans le sens du rayon devant la grille de diffraction (GI), pour une utilisation de celle-ci avec une efficacité optimale de diffraction, indépendamment du sens de polarisation du rayon laser, le rayon rétroactivé vers le générateur laser (LD) touchant la grille de diffraction dans le sens de polarisation d'origine.

9. Source laser lumineuse à fréquence variable selon l'une des revendications 1 à 3,
**caractérisée en ce qu'**
un laser à semi-conducteurs sert de générateur laser (LD).

10. Source laser lumineuse à fréquence variable selon revendication 9,
**caractérisée en ce que**
la facette de sortie du laser à semi-conducteurs est largement anti-reflet.

11. Source laser lumineuse à fréquence variable selon l'une des revendications 1 à 3,
**caractérisée en ce qu'**
une ligne de lasers à semi-conducteurs sert de générateur laser (LD).

12. Source laser lumineuse à fréquence variable selon revendication 11,
**caractérisée en ce que**
la facette d'entrée partiellement réfléchissante d'un guide d'ondes lumineuses se trouve à la place de chacune des images laser, de sorte que plusieurs sources laser lumineuses à fréquences variables synchronisables soient ainsi disponibles et que les rayons des différentes sources laser lumineuses puissent être conduits à des endroits relativement éloignés les uns des autres.

13. Source laser lumineuse à fréquence variable selon l'une des revendications 1 à 3,
**caractérisée en ce qu'**
un collimateur (KO) est disposé entre le générateur laser (LD) et l'élément de dispersion (GI).

14. Source laser lumineuse selon l'une des revendications 1 à 3,
**caractérisée en ce qu'**
un montage constitué d'un miroir terminal de cavité ou d'un rétroréflecteur (L 1, M1), du générateur laser (LM) ainsi que d'un objectif (L 2) et d'un filtre de fréquences spatiales est présent dans le plan focal de l'objectif comme générateur laser comprenant un miroir terminal de cavité; et en ce que ce montage est disposé avec son filtre de fréquences spatiales comme la facette de sortie d'une diode laser.

15. Source laser lumineuse selon l'une des revendications 1 à 3,
**caractérisée en ce qu'**
un miroir terminal de cavité est disposé sur le plan focal arrière de l'objectif KO au lieu de la facette de sortie d'une diode laser et en ce que le générateur laser se trouve à un emplacement quelconque entre ce miroir terminal de cavité (M 2) et l'élément de dispersion (GI).

16. Source laser lumineuse selon revendication 15,
**caractérisée en ce que**
le miroir terminal de cavité (M 2) ne présente qu'une extension géométrique réduite dans le sens de dispersion de l'élément de dispersion (GI).

17. Procédé d'obtention d'un rayonnement laser à spectre filtré pour déclenchement hors d'une cavité à laser et rétroaction simultanée vers celle-ci, le pinceau rayonnant partant du générateur laser comprenant un miroir terminal de cavité étant dispersé angulairement, transversalement à son sens de propagation, avant d'être focalisé, filtré dans le foyer ou à proximité de celui-ci de sorte que seule une bande étroite de longueurs d'ondes du rayon continue à être diffusée, une réflexion de la partie retenue du rayonnement vers le résonateur étant largement empêchée et une part du rayonnement étant, après filtrage dans le foyer également ou dans une image de ce foyer par un réflecteur partiellement perméable, finalement réfléchie dans la cavité de laser, une autre part étant conduite pour utilisation du rayonnement laser,
**caractérisé en ce que**
le filtrage est opéré dans le foyer ou dans une image de celui-ci après focalisation du rayon laser, et que la réflexion est effectuée en relation avec la focalisation perpendiculairement au sens de dispersion, selon le principe d'un rétroréflecteur largement indépendant de la direction, suivant le principe d'un oeil de chat.

18. Procédé d'obtention d'un rayonnement laser à spectre filtré pour déclenchement hors d'une cavité à laser et rétroaction simultanée vers celle-ci,
**caractérisé en ce que**
le pinceau de rayons partant du générateur laser comprenant un miroir terminal de cavité est dispersé et focalisé transversalement à son sens de propagation, filtré et simultanément réfléchi dans le foyer ou à proximité de celui-ci de sorte que seule une bande étroite de longueurs d'ondes du rayon est inversée, la focalisation et la réflexion se déroulant ensemble selon le principe d'un rétroréflecteur largement indépendant de la direction suivant le principe d'un oeil de chat, les pinceaux de rayons propagés dans un sens et en sens inverse étant parallèlement décalés les uns par rapport aux autres, tout en traversant le même composant, la dispersion étant effectuée une seconde fois sur le même composant de manière analogue à la première dispersion, une nouvelle focalisation étant effectuée, un filtrage étant effectué par un filtre de fréquences spatiales en forme de fente dans le foyer ou à proximité de celui-ci, de sorte que seule une bande étroite de longueurs d'ondes continue à être propagée, et que finalement une réflexion partielle soit produite sur un réflecteur formé de manière à être partiellement perméable après filtrage également dans le foyer ou dans une image de celui-ci, de sorte qu'une partie du rayon retourne vers le générateur laser par le même chemin, et qu'une autre partie est propagée au travers pour utilisation du rayonnement laser.

19. Procédé selon l'une des revendications 17 ou 18,
**caractérisé en ce que**
la séparation du rayonnement rétroactivé et du rayonnement déclenché a lieu sur une seule surface.

20. Procédé d'obtention d'un rayonnement laser à spectre filtré pour déclenchement hors d'une cavité à laser et rétroaction simultanée vers celle-ci,
**caractérisé en ce que**
le pinceau de rayons partant du générateur laser comprenant un miroir terminal de cavité est dispersé et focalisé transversalement à sa direction de propagation, filtré et simultanément réfléchi dans le foyer ou à proximité de celui-ci de sorte que seule une bande étroite de longueurs d'ondes du rayon est inversée, la focalisation et la réflexion se déroulant ensemble selon le principe d'un rétroréflecteur largement indépendant de la direction suivant le principe d'un oeil de chat, les pinceaux de rayons propagés dans un sens et en sens inverse étant parallèlement décalés les uns par rapport aux autres, de manière à se recouvrir partiellement, une seconde dispersion étant effectuée de manière analogue à la première sur le premier composant, en ce que la partie non recouvrante du pinceau de rayons est séparée et focalisée à nouveau, filtrée par un filtre de fréquences spatiales en forme de fente dans le foyer ou à proximité de celui-ci, de sorte que seule une bande étroite de longueurs d'ondes quitte la cavité de laser pour utilisation du rayonnement laser, et que la partie recouvrante du pinceau de rayons parvienne à nouveau au générateur laser.
